# EUROPEAN PATENT APPLICATION

(11) **EP 1 628 347 A1**
(43) Date of publication of application: **22.02.2006**
(21) Application number: 04019694.1
(22) Date of filing: 19.08.2004
(51) Int. Cl.: H01L 25/065, H01L 23/495

(54) **Semiconductor chip leadframe module**

(71) Applicant: OPTIMUM CARE INTERNATIONAL TECH. INC., Neihu District, Taipei City 114 (TW)
(72) Inventor: Lien, Jeffrey, Shihlin District Taipei City 111 (TW)
(74) Representative: Beck, Michael Rudolf

(57) **Abstract**

A semiconductor chip leadframe module is disclosed, it is to provide selectively installed and directly connected common electrical leads among multiple leadframe units, and to provide independent electrical leads which can be connected respectively to circuit board (such as printed circuit board), the leadframe module thus formed provide space for the assembly of multiple chips, and the common signals on the chips can be connected to common electrical leads and then transferred to the circuit board, in contrary, the independent signals are transferred by the circuit board through independent electrical leads, the circuit board used layers and the amount of circuit layouts can thus be reduced, circuit board of lighter weight and smaller form factor can thus be achieved, furthermore, the saving in the usage of the circuit board space further provides more room for the plan and implementation of other functional structures or devices, etc.

## Description

### BACKGROUND OF THE INVENTION

### 1.Field of the Invention:

This invention relates to a semiconductor chip leadframe module, it relates more specifically to a semiconductor chip leadframe structure and design which provides means for the direct connection of common signals of multiple chips, it also provides means for the module to be connected independently to other printed circuit board or flexible circuit board for the electrical signals.

### 2.Description of the Related Art:

The composition of conventional specific function PCB card, for example: Random Access Memory (RAM), display card or mother board, etc., is to solder multiple transistors and electronic components, the electrical signal connection provided by transistors and electronic components thus achieve the functions of logic calculation and memory access; in the prior art signal transfer technology among transistors, the multiple, leads of transistors have to be independently connected through PCB, therefore, PCB has to be designed with complicated printed circuit and soldering pad to correspond to the multiple electrical leads in the transistors, this causes great difficulty for the circuit board layout from board manufacturer or designer's point of view, this is especially true in the case when there is limited space in the circuit board space or when many functional transistors have to be assembled, to deal with such issues, multiple layers PCB has to be used, this not only causes the difficulty in the cost lowering, but also limit the expalldability and the implementation of other structural or functional devices due to a short of space.

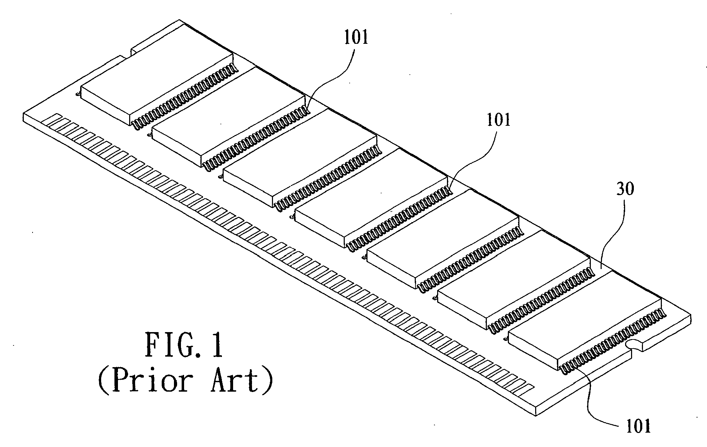

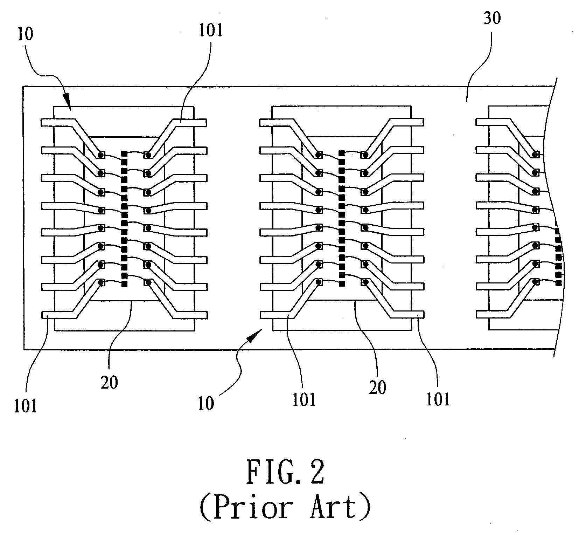

The above-mentioned difficulties on circuit board designing and manufacturing is because of the independent soldering connection between the electrical leads of transistors and the printed circuit board, this is as shown in figure 1 and figure 2, it is prior art transistor with leadframe 10 and prepared to be soldered in parallel onto a PCB, each leadframe 10 contains multiple electrical leads 101 structure, one end of electrical leads 101 is connected electrically to a functional chip 20 while the outer end or bottom end is soldered connected to PCB 30, this kind of design thus created difficulty in PCB layout planning or manufacturing as mentioned above.

### SUMMARY OF THE INVENTION

This invention is to provide a semiconductor chip leadframe module, which contains multiple leadframe units arranged in parallel and is installed selectively with common electrical leads which can be used to connect directly the common signals of some chips, this module further contains independent electrical leads structure which allows chips to be connected respectively to circuit board (such as printed circuit board), it also allows some common signals to be connected to common electrical leads and further transferred to the circuit board ,and the independent signals are transferred by the circuit board through independent electrical leads; therefore, the circuit board (such as printed circuit board) used layers and the amount of circuit layouts can be reduced ,circuit board thus manufactured can be of light weight, small volume and smaller form factor and of course of low cost .Most importantly, a lot of space is saved in the circuit board and the goal of easy to plan and implement other functional structure or device is thus achieved.

This invention is to provide a semiconductor chip leadframe module, the common electrical leads mentioned above can also be of shape which are not inter-connected, they can be just connected to a transfer medium in advance, the pre-planned and pre-installed common channels in the transfer medium can allow the interconnection to be free from the circuit board.

Furthermore, through the leadframe structure technology disclosed above, this invention also provides an assembly structure and design for the connections between chips and the leadframe disclosed above, in this invention, some chips are simply assembled and fixed respectively onto the leadframe, and the bonding parts (metallic conducting wire connecting parts) of chips and leadframe are selectively and partly encapsulated with encapsulant to form a package structure; or the structure can be selected not to be encapsulated partly with encapsulant but only a cover is used to enclose the chips when the leadframe is installed onto one side or two sides of the circuit board, the structure thus formed for transistors is of low manufacturing cost.

### BRIEF DESCRIPTIONS OF THE DRAWINGS

Figure 1 is a stereo diagram showing an assembly of prior art PCB and transistor.
Figure 2 is a prior art leadframe structure for transistors.
Figure 3 shows the common electrical leads structure for the leadframe unit in this invention.
Figure 4 shows the common electrical leads structure for the leadframe unit for another embodiment in this invention.
Figure 5 shows the common electrical leads structure on the sides of the leadframe unit in this invention.
Figure 6 shows the common electrical leads structure on the sides of the leadframe unit for another embodiment in this invention.
Figure 7 shows the partly encapsulated part structure on the wire-bonding part in this invention.
Figure 8 shows a structure of the use of protection cover to protect chip and leadframe in this invention.
Figure 9 shows one embodiment of this invention through the use of transfer medium as common electrical lead.

### DETAILED DESCRIPTION OF THE PREFERRED EMBODIMENT

The features of the structure and other functions and purposes of the current invention are described in detail in the followings according to the embodiment examples in the attached figures:

As shown in the attached figure, this invention is a structure and design of "semiconductor chip leadframe module", the leadframe module is a metallic conductor which can be placed or assembled with multiple chips 2 and contains multiple leadframe units 1 that are arranged in parallel, wherein:

Each leadframe unit 1 contains a center hollow part 11 which forms spaced arranged multiple leads 12 on its two sides or four sides, and each lead 12 further comprising a first conducting end 121 to be connected to chip 2 and a second conducting end 122 to be soldered to circuit board, the selected leads 12 of leadframe unit 1 are installed with common electrical leads of directly connected structure in accordance with the circuit layout requirements of chips 2 or circuit board, furthermore, the leads 12 of leadframe unit 1 comprising independent electrical leads B which are indirectly connected and dependent on outer circuit board (such as printed circuit board or flexible circuit board)for electrical transfer , a leadframe module with many leadframe units 1 which provide places for chips 2 to be attached to is thus formed;

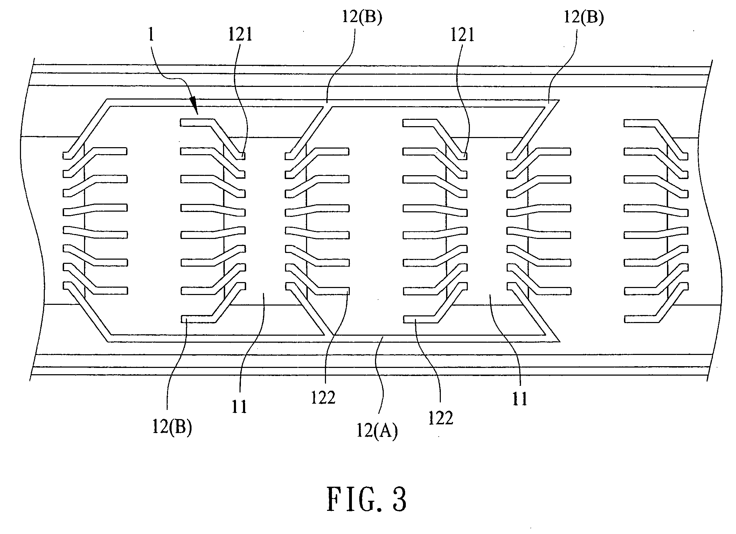

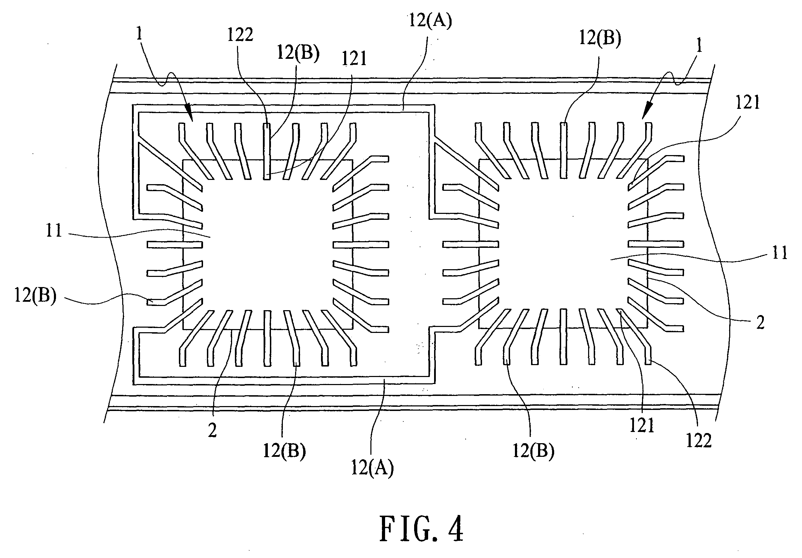

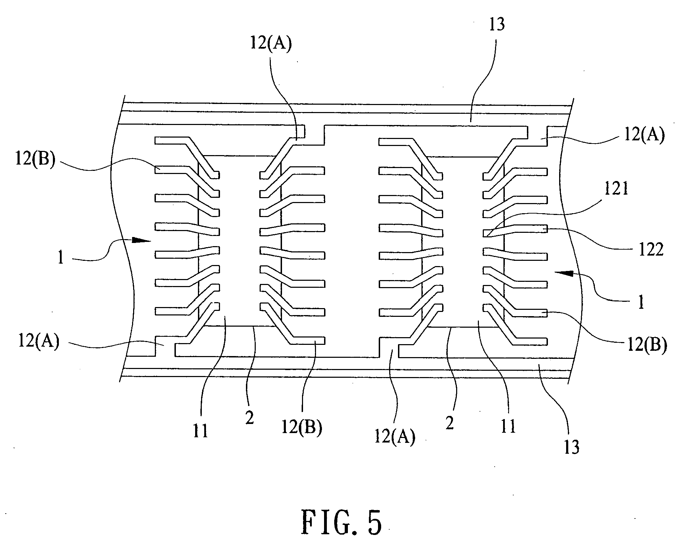

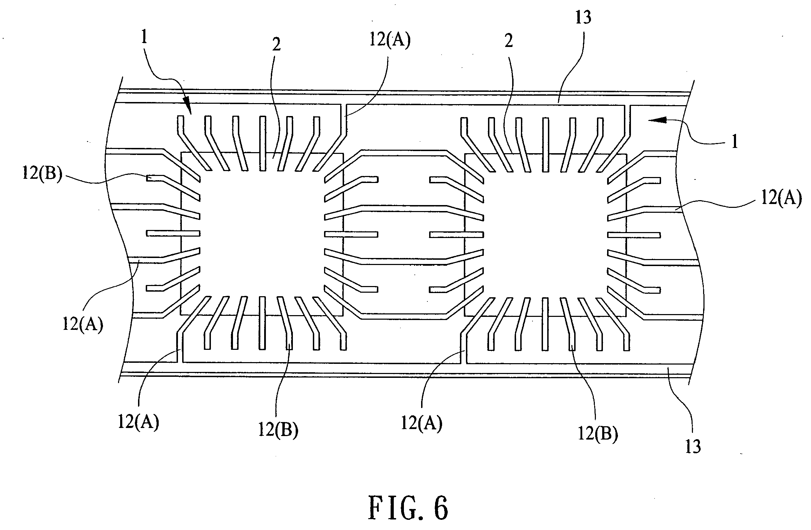

As mentioned above for the embodiment of current invention, the common electrical leads A of the leadframe units 1 are directly connected and located at the adjacent parts of leadframe units 1, and the installed independent electrical leads B can be soldered to circuit board ( as shown in figure 3 and figure 4) ; furthermore, connecting frames 13 can be installed at the peripherals of selected sides the leadframe unit 1 mentioned above, connecting frames 13 is thus connected to selected leads 12 to form common electrical leads A, and independent electrical leads B which can be soldered to circuit board are also formed (as shown in figure 5 and figure 6), a chip leadframe module is thus formed where the common signals from chips 2 can be connected directly with common electrical leads A and then transferred to devices such as circuit board while the independent signals are transferred by circuit board directly through independent electrical leads B.

Through the use of the design disclosed in this invention with common electrical leads A which connect directly many leadframe units 1 and with independent electrical leads B which are not connected to each other, one can let the common signals of chips 2 be connected directly with common electrical leads A and then transferred to devices such as circuit board to reduce the use of channels passing through circuit board (the printed circuit in the circuit board), the independent signals of chips 2 are still connected to circuit board through independent electrical leads B ,it is thus clear that this invention can achieve the easiness in circuit board layout and the saving in the circuit board space ,it can also reduce the layers used in multiple layer circuit board (such as multiple layer printed circuit board), the overall structure of circuit board can thus be of light weight and small form factor, most importantly, the chip leadframe module structure in this invention can reduce the channels used in circuit board, the space saved from it can thus be used to implement other functional transistors or structures, the plan and design thus become easier and lower cost can be easily achieved.

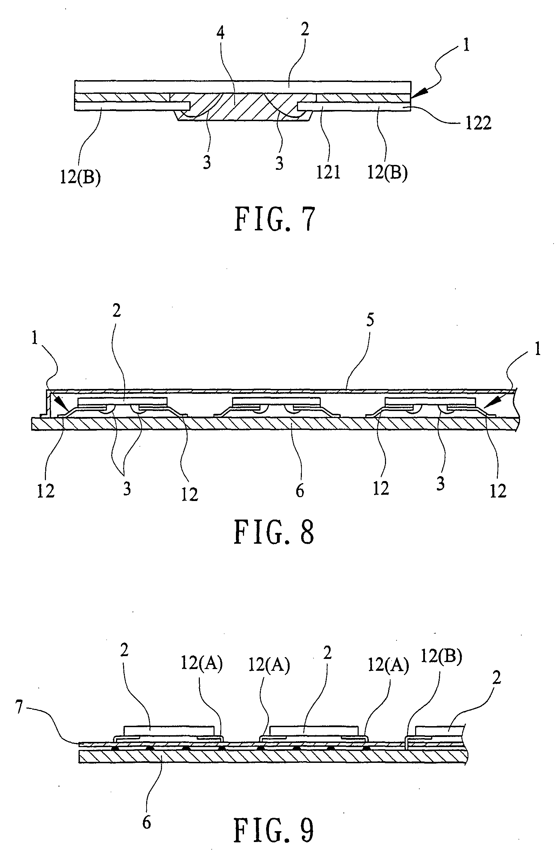

The embodiment of the current invention is not limited to the above-mentioned scope, (as shown in figure 9) the common electrical leads A of the leadframe units 1 can also be not connected together, they can be connected respectively to transfer medium 7 (such as flexible thin board) equipped with electrical channels, the transfer medium 7 comprising common electrical connection effect, it then transfer the electrical signals to devices such as circuit board, therefore, the signals in common electrical leads A don't have to be transferred through outer circuit board, but the independent electrical leads B are still connected to circuit board directly.

Furthermore, through the use of chip leadframe structure and design, multiple chips 2 can be attached to the leadframe units 1 respectively, chip 2 is connected directly to the first conducting end 121 of leadframe unit 1, or further step can be taken to selectively connect the first conducting end 121 to chip 2 through metallic conducting wire 3 (wire-bonding), and the wire-bonding parts (the connecting part of metallic conducting wire 3) of chip 2 and leadframe unit 1 can be selected to form a package structure with partly encapsulated body 4 (as shown in figure 7) such that the wire-bonding part of metallic conducting wire 3 can be stably fixed and protected, the chip peripheral overall package structure of prior art can thus be eliminated, therefore ,manufacturing and material usage cost can be greatly reduced; in another embodiment, one can also form an assembly structure comprising leadframe module and chip 2 without the use of partly encapsulated body 4,furthermore, one can form an assembly comprising leadframe module and one side or two sides of circuit board 6, and use a protection cover 5 to cover leadframe unit 1 respectively or together (as shown in figure 8), the structure thus formed can protect leadframe module, chip 2 and the wire-bonding part of metallic conducting wire 3, this structure also eliminate the conventional process of perfonning an overall package on the chip peripherals, the goal of reducing manufacturing and inaterial usage cost can thus be achieved.

Summarize the above descriptions, current invention of "semiconductor chip leadframe module" achieved through delicate structure and design does possess the requirements of utility and invention for a patent, its embodiments are also inventive, we therefore submit a patent application.

## Claims

1. A semiconductor chip leadframe module comprising multiple leadrfame units; each leadframe unit further comprising a hollow part in the center, multiple leads which are spaced arranged are formed on the sides of hollow part, each lead further comprising a first conducting end to be connected to chip, and a second conducting end to be soldered to other devices; interconnected common electrical leads are installed in the space among selected leads of each leadframe unit, other leads are formed to be independent electrical leads which are indirectly connected and dependent on the electrical transfer by circuit board ,through this structure, the common signals on the chip can be connected by common electrical leads channels and transferred to the circuit board, and the independent signals are transferred by circuit board channels through the independent electrical leads.

2. The semiconductor chip leadframe module of claimed 1 wherein the common electrical leads of said leadframe unit are not directly connected in shape, they are independently and respectively connected to a transfer medium with electrical channels, the transfer medium comprises the common electrical connections and transfer further to the circuit board, on the other hand, the independent electrical leads can still be connected to circuit board directly.

3. The semiconductor chip leadframe module of claimed 1 wherein said common electrical leads can be formed in directly connected shape in the adjacent parts of each leadframe unit.

4. The semiconductor chip leadframe module of claimed 1 wherein said common electrical leads are connected frames which are selectively installed in the peripheral of each leadframe unit, they are used to be connected to selected electrical leads.

5. The semiconductor chip leadframe module of claimed 1 wherein said leadframe unit provides a place for the chip to be attached to, therefore, the chip and the first conducting end of the leadframe unit can be connected with metallic conducting wire, the metallic conducting wire connected part is further partly encapsulated to form a package structure.

6. The semiconductor chip leadframe module of claimed 1 wherein said leadframe unit provides a place for the chip to be attached to, therefore, the chip and the first conducting end of the leadframe unit can be connected with metallic conducting wire, the leadframe module and at least one side of the circuit board form an assembly, a protection cover is used to cover leadframe and chip together or respectively.
